# EUROPÄISCHE PATENTSCHRIFT

(11) **EP 3 491 738 B1**
(45) Veröffentlichungstag und Bekanntmachung des Hinweises auf die Patenterteilung: **14.12.2022**
(21) Anmeldenummer: 17764512.4
(22) Anmeldetag: 26.07.2017
(51) Int. Cl.: H03K 17/691, H03K 17/0814, H03K 17/687, H03K 17/18, H03K 17/06

(54) **VERFAHREN UND VORRICHTUNG ZUR ANSTEUERUNG EINES HALBLEITERSCHALTERS**
METHOD AND DEVICE FOR CONTROLLING A SEMICONDUCTOR SWITCH
PROCÉDÉ ET DISPOSITIF D'EXCITATION D'UN COMMUTATEUR STATIQUE

(30) Priorität: 28.07.2016 DE 102016213944
(43) Veröffentlichungstag der Anmeldung: 05.06.2019
(73) Patentinhaber: Ellenberger & Poensgen GmbH, 90518 Altdorf (DE)
(72) Erfinder: BÖSCHE, Dirk, 38536 Seershausen (DE); WILKENING, Ernst-Dieter, 38108 Braunschweig (DE)
(74) Vertreter: FDST Patentanwälte
(86) Internationale Anmeldenummer: PCT/EP2017/068847
(87) Internationale Veröffentlichungsnummer: WO 2018/019869

(56) Entgegenhaltungen:
- DE-A1- 3 741 713
- DE-A1-102011 087 434
- DE-A1-102013 114 259
- US-A- 4 438 356
- US-A1- 2009 212 759

## Beschreibung

Die Erfindung betrifft ein Verfahren und eine Vorrichtung zur Ansteuerung eines Halbleiterschalters.

Elektromotorisch betriebene Antriebsmaschinen weisen typischerweise einen Elektromotor auf, welcher mittels eines Umrichters an einem Netz oder einem Energiespeicher angeschlossen ist. Zum Aufladen des Energiespeichers beziehungsweise für eine Rückspeisung in das Netz wird häufig elektrische Energie bei einem rekuperativen oder generatorischen Betrieb des Elektromotors in den Energiespeicher beziehungsweise das Netz eingespeist. Zur Absicherung dieses (Last-)Stromkreises sind insbesondere bidirektionale Schutzschaltvorrichtungen gewünscht, welche in der Lage sind, einen Stromfluss in beide Richtungen zu führen und zu schalten.

Derartige Schutzschaltvorrichtungen weisen in der Regel einen Steuer- und/oder Regelschaltkreis sowie einen hiermit gekoppelten Lastschaltkreis zur Schaltung des Laststromkreises auf. Zu diesem Zwecke umfasst der Lastschaltkreis mindestens einen elektronisch betätigbaren Halbleiterschalter, der mittels einer Treiberschaltung des Lastschaltkreises angesteuert wird. Der Steuerschaltkreis und der Lastschaltkreis sind vorzugsweise galvanisch voneinander getrennt, wobei Steuersignale des Steuerschaltkreises mittels eines Optokopplers signaltechnisch an den Lastschaltkreis übermittelt werden.

In der US 4 438 356 A ist ein Halbleiterrelais mit MOSFET-Leistungsschaltvorrichtungen offenbart. Die US 4 438 356 A offenbart hierbei ein Gleichspannungs-Ausgangsrelais unter Verwendung eines einzelnen Leistungs-MOSFET-Bauelements, und ein Wechselspannungs-Ausgangsrelais unter Verwendung von Leistungs-MOSFETs mit Reihenschaltung.

Aus der US 2009/212759 A1 ist eine transformatorisolierte Analog-Digital-Wandler-Rückkopplungsvorrichtung und -methode bekannt. Die Rückkopplungsvorrichtung ist eine Schaltung mit einem Analog-Digital-Wandler zum Empfang eines analogen Eingangssignals und einem Transformator mit einer ersten Wicklung, die einen modulierten Ausgang des Analog-Digital-Wandlers empfängt. Eine zweite Wicklung des Transformators liefert einen isolierten Datenausgang des Analog-Digital-Wandler. Ein Demodulator ist mit der zweiten Wicklung des Transformators gekoppelt und demoduliert den isolierten Ausgang, um eine digitale Darstellung des analogen Eingangssignals zu erzeugen.

Der Erfindung liegt die Aufgabe zugrunde, ein verbessertes Ansteuerverfahren für einen elektronischen Halbleiterschalter anzugeben, der in einen Laststromkreis geschaltet ist. Der Erfindung liegt weiterhin die Aufgabe zugrunde, eine besonders geeignete elektronische Schaltvorrichtung zum Schutz eines Laststromkreises anzugeben.

Die Aufgabe wird hinsichtlich des Verfahrens mit den Merkmalen des Anspruchs 1 und hinsichtlich der Schaltvorrichtung mit den Merkmalen des Anspruchs 4 erfindungsgemäß gelöst. Vorteilhafte Ausgestaltungen und Weiterbildungen sind Gegenstand der jeweiligen Unteransprüche.

Das erfindungsgemäße Verfahren ist dazu geeignet und eingerichtet einen, in einen Laststromkreis geschalteten elektronischen Halbleiterschalter anzusteuern. Zu diesem Zwecke ist der Halbleiterschalter zwischen einem an eine Quelle geführten Eingangsanschluss und einem an eine Last geführten Ausgangsanschluss des Laststromkreises geschaltet.

Zur Ansteuerung des Halbleiterschalters ist ein an eine Versorgungsspannung angeschlossener Steuerschaltkreis vorgesehen, welcher eine primärseitig an einen Transformator und an die Versorgungsspannung angeschlossene Brückenschaltung aufweist. Weiterhin ist ein sekundärseitig an den Transformator angeschlossener Lastschaltkreis vorgesehen, welcher eine Treiberschaltung für den Halbleiterschalter aufweist. Die Treiberschaltung beziehungsweise der Lastschaltkreis sind hierbei geeigneterweise an einen Steueranschluss des Halbleiterschalters geführt.

Verfahrensgemäß wird die Brückenschaltung mit einem Schwellwertsignal angesteuert, in dessen Abhängigkeit ausgangsseitig ein Primärsignal an einer Primärwicklung des Transformators erzeugt wird. Vorzugsweise wird das Primärsignal hierbei durch die Ansteuerung der Brückenschaltung mit dem Schwellwertsignal aus der Versorgungsspannung erzeugt. Das Primärsignal wird anschließend mit dem Transformator als ein Sekundärsignal an den vom Steuerschaltkreis galvanisch getrennten Lastschaltkreis übertragen. Das Sekundärsignal wird der Treiberschaltung des Lastschaltkreises zugeführt, welche hieraus ein Ansteuersignal für den Halbleiterschalter erzeugt.

Das Schwellwertsignal dient somit im Wesentlichen als Steuersignal für den Halbleiterschalter, wobei die Information zur Auslösung eines Einschalt- oder Ausschaltvorgangs sowohl in dem Primärsignal als auch in dem Sekundärsignal enthalten sind. Dies bedeutet, dass das Sekundärsignal als ein schwellwertartiges Steuersignal der Treiberschaltung zugeführt wird, welche in dessen Abhängigkeit das Ansteuersignal für den Halbleiterschalter erzeugt. Beispielsweise erzeugt die Treiberschaltung oberhalb eines Schwellwertes des Sekundärsignals das Ansteuersignal für den Halbleiterschalter. Unterschreitet das Sekundärsignal diesen Schwellwert, so wird beispielsweise keine Betriebsspannung von der Treiberschaltung erzeugt.

Einerseits sind durch die Signalübertragung mittels eines Transformators sehr geringe Schaltverzugszeiten der Schaltvorrichtung gewährleistet. Dies bedeutet, dass bei einer Änderung des steuerschaltkreisseitigen Schwellwertsignals ein schnelles Umschalten des lastschaltkreisseitigen Halbleiterschalters ermöglicht ist.

Andererseits überträgt der Transformator zusätzlich zu den Steuersignalen für das (Um-)Schalten des Halbleiterschalters auch eine für den Betrieb der Treiberschaltung benötigte Energie an den Lastschaltkreis, und dies bereits galvanisch getrennt, so dass keine weiteren Mittel zur galvanischen Trennung erforderlich sind. Mit anderen Worten ist es möglich, dass die Treiberschaltung des Lastschaltkreises lediglich mit dem Sekundärsignal, das bedeutet mit der an die Sekundärwicklung des Transformators übertragenen Leistung beziehungsweise Spannung, betrieben wird. Dadurch entfallen zum Beispiel zusätzliche Netzteile für den Lastschaltkreis, wodurch eine möglichst bauteilreduzierte Ausführung des Lastschaltkreises ermöglicht ist.

In einer vorteilhaften Weiterbildung wird das Schwellwertsignal mittels eines der Brückenschaltung vorgeschalteten Signalverstärkers verstärkt. Dadurch ist sichergestellt, dass mit dem Transformator eine hinreichend hohe Leistung zum Betrieb der Treiberschaltung an den Lastschaltkreis übertragen wird.

In einer geeigneten Ausführung wird der Halbleiterschalter zum Umschalten in den Ausschaltzustand (elektrisch nicht leitender Zustand, sperrender Zustand) mit einem negativen Spannungswert des Ansteuersignals der Treiberschaltung angesteuert. Unter einem Spannungswert des Ansteuersignals ist hierbei insbesondere eine Pulshöhe oder Pegel beziehungsweise eine Amplitude des Ansteuersignals zu verstehen. Durch die Ansteuerung mit einem negativen Spannungswert des Ansteuersignals werden möglichst geringe (Um-)Schaltzeiten des Halbleiterschalters ermöglicht. In einer Anwendung mit erhöhten Sicherheitsanforderungen ist es hierbei beispielsweise denkbar, dass der Halbleiterschalter im Ausschaltzustand dauerhaft mit einem negativen Spannungswert angesteuert wird.

Die erfindungsgemäße elektronische Schaltvorrichtung ist zum Unterbrechen eines Laststromkreises mit mindestens einem elektronischen Halbleiterschalter geeignet und eingerichtet. Der oder die Halbleiterschalter sind hierbei zwischen einem an eine Quelle geführten Eingangsanschluss und einem an eine Last geführten Ausgangsanschluss des Laststromkreises geschaltet.

Die Schaltvorrichtung umfasst einen an eine Versorgungsspannung angeschlossenen Steuerschaltkreis mit einer primärseitig an einen Transformator und an die Versorgungsspannung angeschlossenen Brückenschaltung, sowie einen sekundärseitig an den Transformator angeschlossenen Lastschaltkreis mit einer Treiberschaltung für den mindestens einen Halbleiterschalter. Der Lastschaltkreis beziehungsweise die Treiberschaltung ist hierbei an einen Steueranschluss des Halbleiterschalters geführt.

Im Betrieb überträgt der Transformator ein Primärsignal von dem Steuerschaltkreis galvanisch getrennt an den Lastschaltkreis, in dem die Treiberschaltung für den Halbleiterschalter geschaltet ist. Ein Sekundärsignal des Transformators ist an die Treiberschaltung geführt, welche in der Folge ein Ansteuersignal für den Halbleiterschalter erzeugt. Dadurch ist eine besonders geeignete elektronische Schaltvorrichtung realisiert, die insbesondere einen kompakten Aufbau mit wenigen diskreten elektronischen Bauteilen aufweist.

In einer zweckmäßigen Ausgestaltung ist der Steuerschaltkreis über einen Unterspannungsauslöser an die Versorgungsspannung angeschlossen. Dadurch weist die Schaltvorrichtung einen integrierten Unterspannungsschutz auf. Bei einem Ausfall der Versorgungsspannung wird der Steuerschaltkreis, und somit der oder jeder Halbleiterschalter im Lastschaltkreis, selbsttätig abgeschaltet. Dadurch werden undefinierte Schaltzustände, welche eine Beschädigung oder Zerstörung des Halbleiterschalters bewirken könnten, vorteilhaft und einfach vermieden.

In einer vorteilhaften Ausbildung ist der Brückenschaltung ein Signalverstärker vorgeschaltet. Der Signalverstärker verstärkt das Schwellwertsignal für die Ansteuerung der Brückenschaltung. Der Signalverstärker weist in einer geeigneten Weiterbildung insbesondere zwei hintereinander geschaltete Verstärkerstufen auf, welche ausgangsseitig jeweils an einen Brückenzweig der Brückenschaltung geführt sind. Die Verstärkerstufen sind beispielsweise als invertierte Push-Pull-Verstärker ausgeführt, wobei das Ausgangssignal der ersten Verstärkerstufe einerseits an einen Brückenzweig und andererseits an den Eingang der zweiten Verstärkerstufe geführt ist.

Erfindungsgemäß ist der oder jeder Halbleiterschalter mittels einer an die Treiberschaltung und an den Transformator gekoppelten Halbleiterschutzschaltung des Lastschaltkreises auf einen Überstrom überwacht. Die Halbleiterschutzschaltung und die Treiberschaltung sind hierbei vorzugsweise lediglich durch die Leistung des übertragenen Sekundärsignals betrieben. Die Halbleiterschutzschaltung erfasst den Laststrom des Laststromkreises erfindungsgemäß über den Spannungsabfall am Halbleiterschalter selbst. Dies bedeutet, dass keine zusätzlichen (Mess-)Shuntwiderstände benötigt werden. Der Halbleiterschalter ist als ein Leistungstransistor ausgeführt, wobei der Laststrom über die Drain-Source- beziehungsweise die Kollektor-Emitter-Strecke erfasst wird. Der Laststrom ergibt sich hierbei erfindungsgemäß aus der Kennlinie des eingesetzten Halbleiterschalters. Ab einer vorgebbaren kritischen Stromgrenze wird der Halbleiterschalter in den Ausschaltzustand versetzt. Durch die Kopplung der Halbleiterschutzschaltung an die Treiberschaltung wird verhindert, dass im Falle eines Überstroms ein Ansteuersignal von der Treiberschaltung erzeugt wird.

In einer bevorzugten Ausgestaltung sind zum Zwecke eines bidirektionalen Überlastschutzes des Laststromkreises zwei in Reihe geschaltete Halbleiterschalter zwischen einem Eingangsanschluss und einem Ausgangsanschluss des Laststromkreises geschaltet. Dadurch ist es möglich, mit der Schaltvorrichtung Stromflüsse in beide Richtungen, das bedeutet von einer Last zu einer Quelle und umgekehrt, zu führen und zu schalten. Hierbei ist es beispielsweise denkbar, dass für die beiden Stromrichtungen unterschiedliche Auslöseschwellen der Halbleiterschalter vorgesehen sind. Dies ist zum Beispiel für Anwendungen bei einem rekuperativen Betrieb eines elektromotorischen Kraftfahrzeugs wünschenswert.

In einer denkbaren Ausgestaltung ist den Halbleiterschaltern ein Varistor als Überspannungsschutz parallel geschaltet. Dadurch werden die Halbleiterschalter vor einer Zerstörung oder einer Beschädigung in Folge einer Überspannung geschützt.

Nachfolgend ist ein Ausführungsbeispiel der Erfindung anhand einer Zeichnung näher erläutert. Darin zeigen in schematischen und vereinfachten Blockdarstellungen:
- Fig. 1: eine Schaltvorrichtung mit einem Steuerschaltkreis und einem galvanisch getrennten Lastschaltkreis,
- Fig. 2: den Steuerschaltkreis mit einem Unterspannungsauslöser und mit einem Signalverstärker sowie mit einer Brückenschaltung,
- Fig. 3: den Lastschaltkreis mit einer Treiberschaltung und mit einer Halbleiterschutzschaltung sowie mit zwei elektronischen Halbleiterschaltern,
- Fig. 4: ausschnittsweise den Unterspannungsauslöser,
- Fig. 5: ausschnittsweise den Signalverstärker mit zwei Verstärkerstufen,
- Fig. 6: ausschnittsweise die Brückenschaltung mit zwei an einen Transformator geführten Brückenzweigen, und
- Fig. 7: ausschnittsweise die Treiberschaltung.

Einander entsprechende Teile und Größen sind in allen Figuren stets mit den gleichen Bezugszeichen versehen.

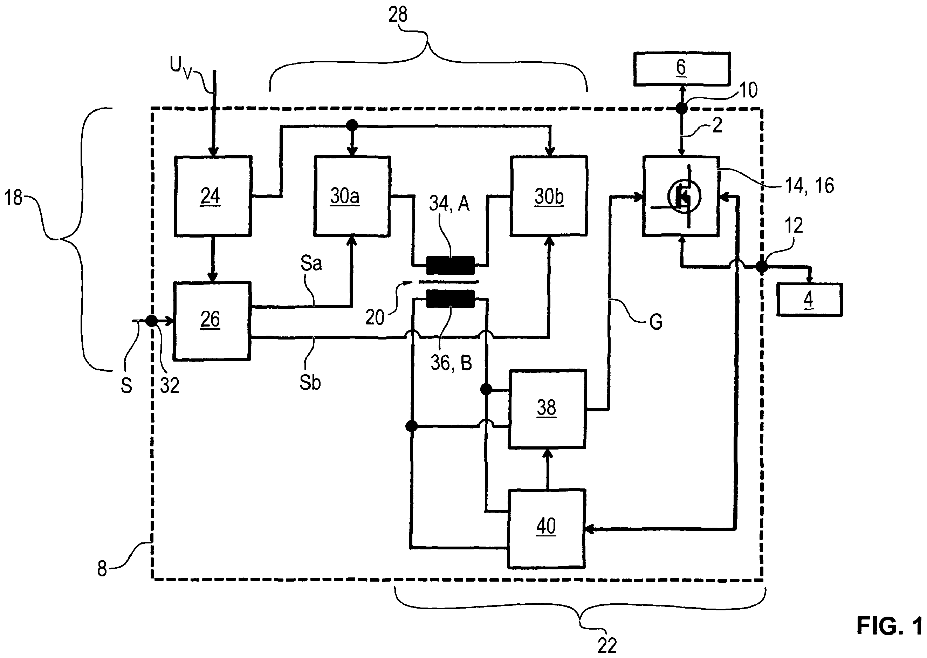

In der Fig. 1 ist ein Laststromkreis 2 zwischen einer Last 4 und einer Quelle 6 dargestellt. In den Laststromkreis 2 ist eine Schaltvorrichtung 8 geschaltet. Die elektronische Schaltvorrichtung 8 ist dazu geeignet und eingerichtet, die Last 4 beziehungsweise die Quelle 6 bidirektional vor einem Überstrom zu schützen. Dies bedeutet, dass die Schaltvorrichtung 8 dazu vorgesehen ist, Stromflüsse in beide Richtungen des Laststromkreises 2 zu führen und zu schalten. Zu diesem Zwecke ist die Schaltvorrichtung 8 mit einem Eingangsanschluss 10 und einem Ausgangsanschluss 12 zwischen der Quelle 6 und der Last 4 verschaltet.

Zwischen den Anschlüssen 10 und 12 sind zwei in Reihe geschaltete Halbleiterschalter 14 und 16 zum Zwecke einer bidirektionalen Unterbrechung des Strompfades des Laststromkreises 2 vorgesehen. Die Halbleiterschalter 14 und 16 sind in diesem Ausführungsbeispiel insbesondere als NMOS-Leistungstransistoren ausgeführt.

In dem dargestellten Ausführungsbeispiel ist die Last 4 insbesondere ein elektromotorische Antriebsmaschine und die Quelle 6 ein elektrischer Energiespeicher.

Im Normalbetrieb wird die Last 4 durch die Quelle 6 mit einer elektrischer Energie versorgt, sodass ein Strom von der Last 4 zur Quelle 6 durch den Laststromkreis 2 fließt. Während eines rekuperativen oder generatorischen Betriebs der Last 4 wird ein Strom von der Last 4 (generatorisch) in die Quelle 6 eingespeist.

Die Schaltvorrichtung 8 umfasst im Wesentlichen einen Steuerschaltkreis 18, welcher mittels eines Transformators 20 galvanisch von einem die Halbleiterschalter 14 und 16 aufweisenden Lastschaltkreis 22 getrennt ist. Der Steuerschaltkreis 18 ist hierbei auf der Primärseite des Transformators 20 und der Lastschaltkreis 22 auf der Sekundärseite des Transformators 20 verschaltet. Mit dem Steuerschaltkreis 18 werden die Halbleiterschalter 14 und 16 über den insbesondere als Ferrit-Ringtransformator ausgeführten Transformator 20 gesteuert.

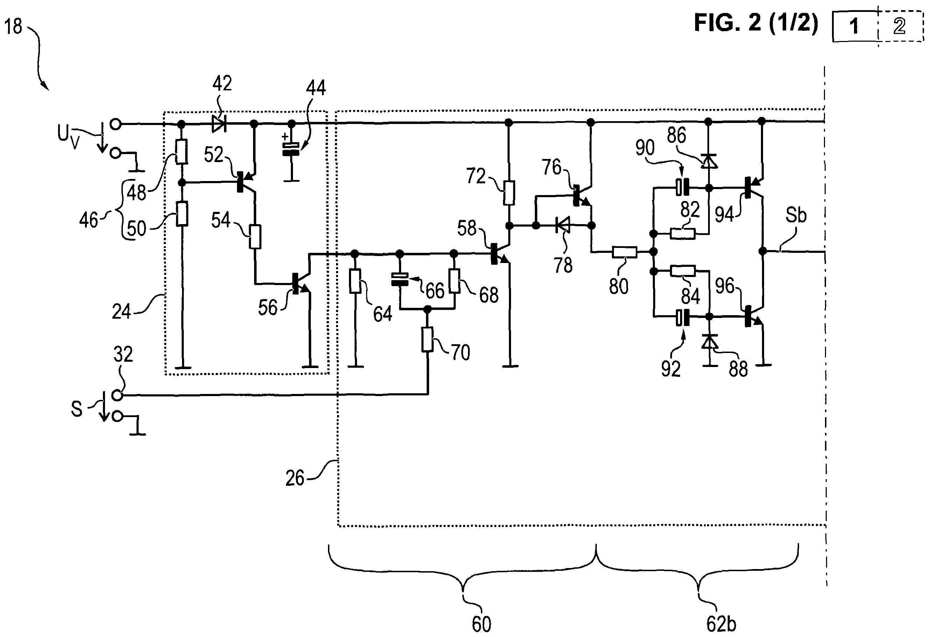

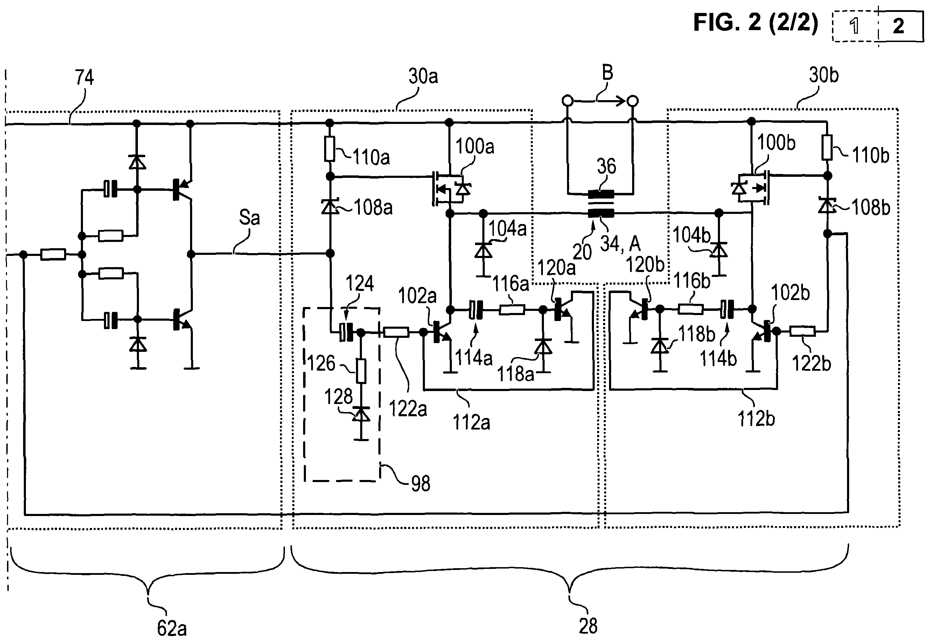

Der in Fig. 2 einzeln dargestellte Steuerschaltkreis 18 ist mittels eines Unterspannungsauslösers 24 als Unterspannungsschutz an eine Versorgungsspannung Uv angeschlossen. Der Steuerschaltkreis 18 weist weiterhin einen Signalverstärker 26, der eine Brückenschaltung 28 mit zwei Brückenzweigen 30a und 30b ansteuert, auf. Ein Schwellwertsignal S wird der Schutzschaltung 8 über einen Anschluss 32 zugeführt.

Das Schwellwertsignal S wird beispielsweise von einem den Laststromkreis 2 überwachenden Controller oder einer Sensoreinheit erzeugt. Das eingespeiste Schwellwertsignal S wird mittels des Signalverstärkers 26 verstärkt und zur Ansteuerung der Brückenschaltung 28 als ein verstärktes Schwellwertsignal Sa dem Brückenzweig 30a und als ein verstärktes Schwellwertsignal Sb dem Brückenzweig 30b zugeführt.

Eine Primärwicklung 34 des Transformators 20 ist ausgangsseitig zwischen den Brückenzweigen 30a und 30b verschaltet. Die Brückenschaltung 28 ist an den Unterspannungsauslöser 24 und somit an die Versorgungsspannung Uv angeschlossen. Die Brückenschaltung 28, insbesondere die Brückenzweige 30a und 30b in Kombination mit dem Transformator 20, ist hierbei als ein selbstschwingender Flusswandler ausgeführt. Hierbei werden die Schaltelemete der Brückenzweige 30a und 30b mit den verstärkten Schwellwertsignalen Sa beziehungsweise Sb derart angesteuert, dass die Brückenzweige 30a und 30b aus der Versorgungsspannung Uv ein Primärsignal A in die Primärwicklung 34 des Transformators 20 einspeisen.

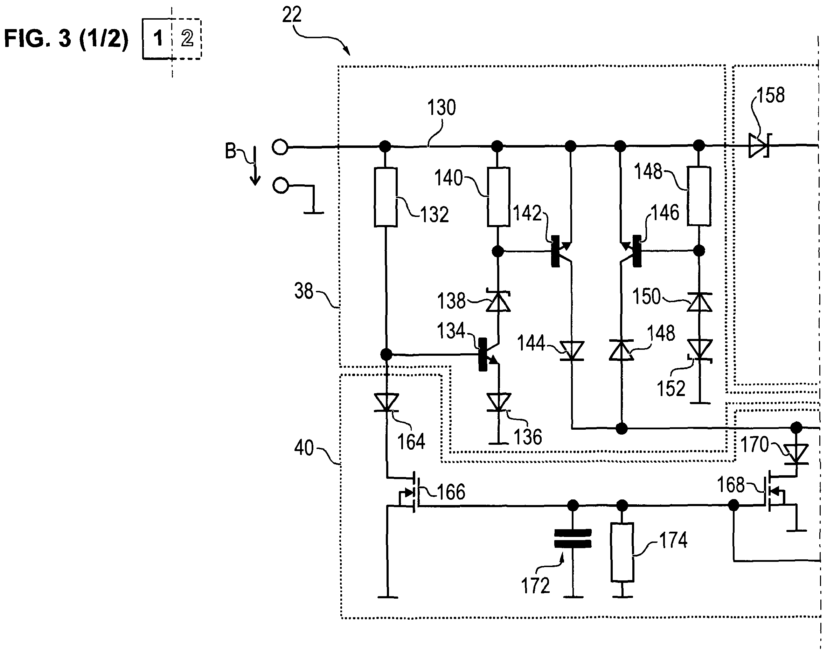

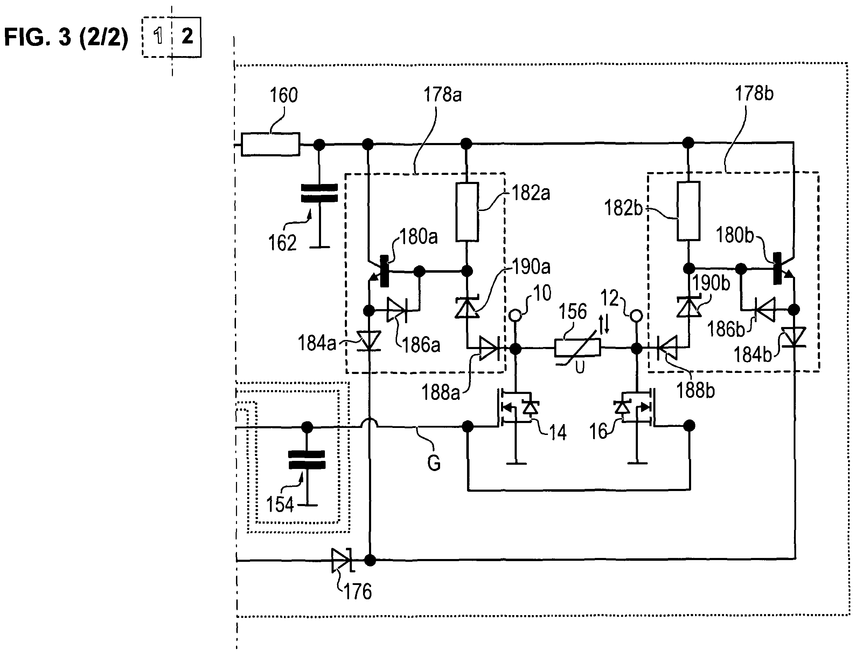

Die Leistung des Primärsignals (Eingangsspannung) A wird an die Sekundärseite des Transformators 20 übertragen, an welcher sie als ein Sekundärsignal (Ausgangsspannung) B an einer mit dem Lastschaltkreis 22 verschalteten Sekundärwicklung 36 abgegriffen wird. Das Sekundärsignal B wird einerseits an eine Treiberschaltung 38 und andererseits an eine Halbleiterschutzschaltung 40 des in Fig. 3 einzeln dargestellten Lastschaltkreises 22 geführt. Die Treiberschaltung 38 erzeugt in Abhängigkeit des Sekundärsignals B ein Ansteuersignal G, welches an die Steueranschlüsse (Gates) der Halbleiterschalter 14 und 16 geführt ist.

Nachfolgend ist der Aufbau des Steuerschaltkreises 18 anhand der Figuren 2 und 4 bis 6 näher erläutert.

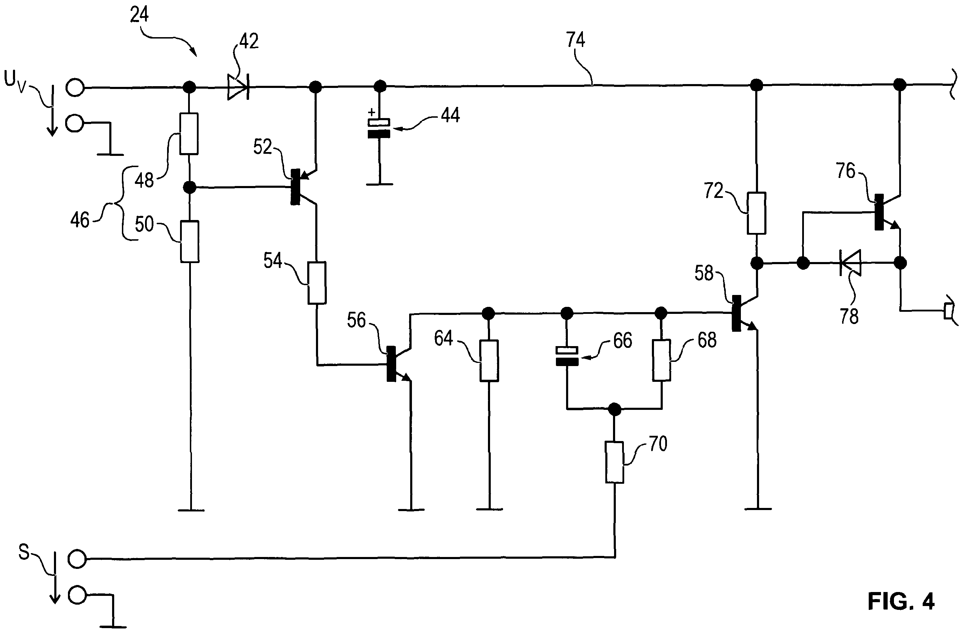

Bei einem Ausfall der Versorgungsspannung Uv, werden der Signalverstärker 26 und die Brückenschaltung 28 durch den Unterspannungsauslöser 24 sicher abgeschaltet. In der Folge werden somit die Halbleiterschalter 14 und 16 durch den in Fig. 4 dargestellten Unterspannungsauslöser 24 ebenfalls automatisch ausgeschaltet. Dadurch werden undefinierte Schaltzustände der Halbleiterschalter 14 und 16 vermieden.

Der Unterspannungsauslöser 24 weist eingangsseitig eine Diode 42 auf, welche an einen gegen Masse geschalteten Kondensator 44 geführt ist. Der Unterspannungsauslöser 24 umfasst weiterhin einen Spannungsteiler 46 mit zwei ohmschen Widerständen 48 und 50, wobei der Widerstand 50 einen wesentlich höheren Widerstandswert als der Widerstand 48 aufweist. Der Spannungsteiler 46 ist einerseits mit dem Widerstand 48 vor die Diode 42 und andererseits mit dem Widerstand 50 gegen Masse geschaltet. Der Spannungsabgriff des Spannungsteilers 46 ist an einen Basisanschluss eines Transistors 52 geführt.

Der Transistor 52 ist emitterseitig zwischen der Diode 42 und den Kondensator 44 verschaltet. Der Kollektoranschluss des Transistors 52 ist über einen ohmschen Widerstand 54 an einen Basisanschluss eines Transistors 56 kontaktiert. Der Transistor 56 ist emitterseitig gegen Masse und kollektorseitig an einen Basisanschluss eines Transistors 58 des Signalverstärkers 28 geführt.

Im Betrieb wird der Kondensator 44 über die Diode 42 aufgeladen. Aufgrund des höheren Widerstandswertes des Widerstands 50 befinden sich der Basis- und der Emitteranschluss des insbesondere als PNP-Transistor ausgeführten Transistors 52 im Wesentlichen auf dem gleichen (Spannungs-)Potential. Dadurch ist der Transistor 52 in einen sperrenden, das bedeutet elektrisch nicht leitfähigen, Zustand geschaltet.

Bei einem Absinken der Versorgungsspannung Uv wird ein Entladen des Kondensators 44 über die Diode 42 verhindert. In der Folge steigt die Emitter-Basis-Spannung des Transistors 52 an, wodurch er in einen leitenden Zustand geschaltet wird. Der resultierende Stromfluss steuert den als NPN-Transistor ausgeführten Transistor 56 auf, welcher den Eingang des Signalverstärkers 26, das bedeutet den Transistor 58, auf Masse zieht. Dadurch wird der Signalverstärker 26 unabhängig vom Schwellwertsignal S ausgeschaltet, wodurch in der Folge die Halbleiterschalter 14 und 16 ausgeschaltet werden(Ausschaltzustand). Der Widerstand 48 begrenzt im Falle eines Kurzschlusses am Anschluss der Versorgungsspannung Uv den Emitter-Basis-Strom des Transistors 52, wodurch dieser vor einer Beschädigung oder Zerstörung geschützt wird.

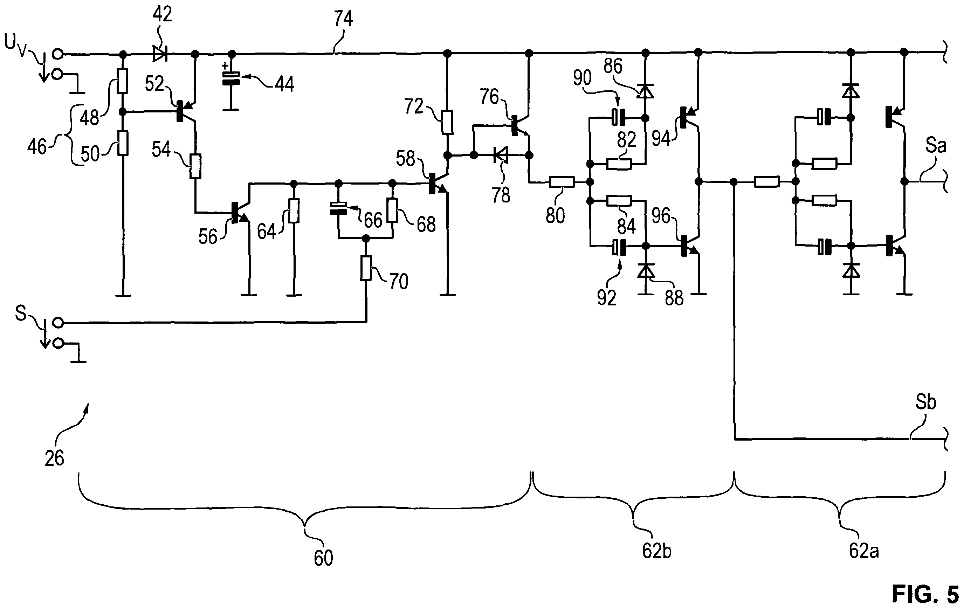

Der in Fig. 5 dargestellte Signalverstärker 26 erzeugt in Abhängigkeit des Schwellwertsignals (Eingangssignal) S und dem Unterspannungsauslöser 24 jeweils ein verstärktes Schwellwertsignal Sa, Sb als Steuersignal (Ausgangssignal, Steuerspannung) für die Brückenzweige 30a und 30b. Der Signalverstärker 26 umfasst im Wesentlichen eine Eingangsstufe 60 sowie zwei Verstärkerstufen 62a und 62b.

Die Eingangsstufe 60 weist einen gegen Masse geschalteten ohmschen Widerstand 64 auf, welcher parallel zum Transistor 56 geschaltet ist. Zwischen dem Widerstand 64 und dem Basisanschluss des Transistors 58 sind ein Kondensator 66 und ein ohmscher Widerstand 68 parallel geschaltet, wobei das Schwellwertsignal S zwischen dem Kondensator 66 und dem Widerstand 68 über einen ohmschen Widerstand 70 zugeführt wird.

Der Transistor 58 ist emitterseitig gegen Masse geschaltet. Kollektorseitig ist der Transistor 58 über einen ohmschen Widerstand 72 an eine die Diode 42 aufweisende Leitung 74 kontaktiert. Parallel zu dem Widerstand 72 ist ein Transistor 76 kollektorseitig an die Leitung 74 angeschlossen, wobei dessen Basisanschluss zwischen dem Kollektoranschluss des Transistors 58 und dem Widerstand 72 geschaltet ist. Zwischen dem Emitteranschluss und dem Basisanschluss des Transistors 76 ist eine Diode 78 geschaltet. Zwischen dem Emitteranschluss des Transistors 76 und der Diode 78 ist ein ohmscher Widerstand 80 der Verstärkerstufe 62a angeschlossen.

Die Verstärkerstufen 62a und 62b sind im Wesentlichen identisch als invertierende Push-Pull-Verstärker aufgebaut, daher ist beispielhaft lediglich der Aufbau der Verstärkerstufe 62b nachfolgend näher erläutert. Des Weiteren sind in den Figuren beispielhaft lediglich die Bauteile der Verstärkerstufe 62b mit Bezugszeichen versehen.

An den Widerstand 80 sind zwei ohmsche Widerstände 82 und 84 angeschlossen, welche mittels jeweils einer Diode 86 beziehungsweise 88 gegen Masse beziehungsweise an die Leitung 74 angeschlossen sind. Parallel zu den Widerständen 82 und 84 ist jeweils ein Kondensator 90, 92 zwischen die Widerstände 80 und 82 und der Diode 86 beziehungsweise zwischen den Widerständen 80 und 84 und der Diode 88 geschaltet.

An den Knotenpunkt zwischen dem Widerstand 82 und der Diode 86 sowie dem Kondensator 90 ist der Basisanschluss eines emitterseitig an die Leitung 74 angeschlossenen Transistors 94 kontaktiert. Entsprechend ist der Knotenpunkt zwischen dem Widerstand 84 und der Diode 88 sowie dem Kondensator 92 an den Basisanschluss eines emitterseitig gegen Masse geschalteten Transistors 96 kontaktiert. Der Transistor 94 ist hierbei kollektorseitig an den Kollektoranschluss des Transistors 96 angeschlossen, wobei zwischen den Transistoren 94 und 96 der Ausgangsanschluss der Verstärkerstufe 62a ist. Der Ausgang der Verstärkerstufe 62b ist hierbei einerseits an den Widerstand 80 der Verstärkerstufe 62a und anderseits an den Brückenzweig 30b geführt. Der Ausgang der Verstärkerstufe 62a ist an den Brückenzweig 30a geführt.

Das Schwellwertsignal S wird in die Eingangsstufe 60 eingespeist. Über die Widerstandswerte der Widerstände 64 und 68 ist vorgebbar, welche Spannungsamplitude (Spannungswert, Spannungspegel) des Schwellwertsignals S zum Durchschalten des Transistors 58 führt. Der Kondensator 66 bewirkt im Einschaltmoment einen kurzzeitigen hohen Basisstrom, sodass der Transistor 58 vergleichsweise schnell durchschaltet. Der Widerstand 70 begrenzt hierbei den fließenden Basisstrom.

Wenn der Transistor 58 durchschaltet wird die Spannung an dessen Kollektoranschluss im Wesentlichen auf 0 V reduziert. Dadurch fließt ein Strom durch die Diode 78 sowie die Widerstände 80 und 82. Der Strom fließt weiterhin kurzzeitig durch den Kondensator 90 und den Basisanschluss des Transistors 94. Dadurch schaltet der Transistor 94 durch, sodass dessen Kollektoranschluss auf die Betriebsspannung der Leitung 74 gezogen wird. Gleichzeitig ist der Transistor 96 nicht leitend geschaltet, da sein Basisanschluss über die Widerstände 80 und 84 sowie der Diode 78 und dem durchgeschalteten Transistor 58 im Wesentlichen auf dem Massepotential ist.

Wird der Transistor 58 ausgeschaltet, das bedeutet nicht leitfähig oder sperrend geschaltet, steigt das Potential an dessen Kollektoranschluss auf die Betriebsspannung der Leitung 74. Der Transistor 76 arbeitet hierbei als ein Spannungsfolger und wirkt aufgrund dessen Stromverstärkung während des Schaltvorgangs als ein Impedanzwandler. Dadurch wird kurzzeitig ein hoher Umschaltstrom für die nachgeschaltete Verstärkerstufe 62b erzeugt. Wenn der Transistor 76 durschaltet, fließt ein Strom durch die Widerstände 80 und 84, sowie kurzzeitig durch den Kondensator 92 und den Basisanschluss des Transistors 96. Dadurch schaltet der Transistor 96 durch, sodass dessen Kollektoranschluss auf Masse gezogen wird. Gleichzeitig sperrt der Transistor 94, da dessen Basisanschluss über die Widerstände 80 und 82 und dem durchgeschalteten Transistor 76 im Wesentlichen auf der Betriebsspannung der Leitung 74 ist.

Die Kondensatoren 90 und 92 ermöglichen einen schnellen Umschaltvorgang, wobei der jeweilige (Umschalt-)Strom durch den Widerstand 80 begrenzt wird. Die Verstärkerstufe 62b arbeitet als invertierender Push-Pull-Verstärker und erzeugt ein Schwellwertsignal Sb für den Brückenzweig 30b, welches weiterhin als ein Eingangssignal in die Verstärkerstufe 62a eingespeist wird. Die Verstärkerstufe 62a erzeugt in der Folge das Schwellwertsignal Sa für den Brückenzweig 30a.

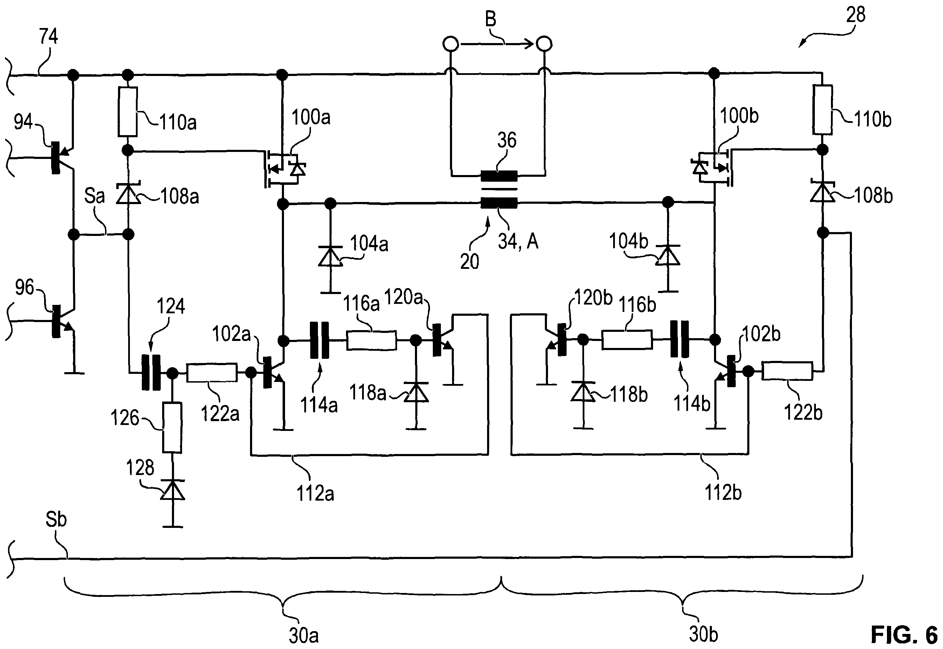

Anhand der Fig. 2 und der Fig. 6 ist im Nachfolgenden der Aufbau der Brückenschaltung 28 näher erläutert. Die Brückenschaltung 28 ist zur Ansteuerung des Transformators 20 als eine H-Vollbrücke (H-Brücke, H-Schaltung) mit zwei im Wesentlichen identischen Brückenzweigen 30a und 30b ausgeführt. Nachfolgend ist insbesondere der Aufbau des Brückenzweiges 30a erläutert. Einander entsprechende Teile und Größen der Brückenzweige 30a und 30b sind jeweils mit Bezugszeichenzusätzen "a" beziehungsweise "b" versehen. Der Brückenzweig 30a weist im Vergleich zu dem Brückenzweig 30b eine zusätzliche Baugruppe 98 auf, welche in der Fig. 2 strichliniert umrandet ist.

Der Brückenzweig 30a umfasst zwei Transistoren 100a und 102a sowie eine Freilaufdiode 104a. Der Brückenzweig 30b weist entsprechend zwei Transistoren 100b und 102b sowie eine Freilaufdiode 104b auf. Aufgrund des Aufbaus der Brückenschaltung 28 als selbstschwingender Flusswandler ist es möglich, sowohl positive als auch negative Ausgangsspannungspulse unterschiedlicher Amplituden als Primärsignal A an den Lastschaltkreis 22 zu übertragen.

Der Ausgang der Verstärkerstufe 62a ist zwischen einem ohmschen Widerstand 106a und einer Z-Diode (Zener-Diode) 108a des Brückenzweigs 30a geschaltet. Die Z-Diode 108a ist mittels eines ohmschen Widerstandes 110a an die Leitung 74 angebunden, wobei zwischen der Z-Diode 108a und dem Widerstand 110a der Gateanschluss des als PMOS-Transistor ausgeführten Transistors 100a verschaltet ist. Der Transistor 100a ist sourceseitig an die Leitung 74 angeschlossen und drainseitig an einen Anschluss der Primärwicklung 34 des Transformators 20 geführt. Zwischen der Primärwicklung 34 und dem Transistor 100a ist die gegen Masse geschaltete Freilaufdiode 104a angeordnet.

Der insbesondere als NPN-Transistor ausgeführte Transistor 102a ist kollektorseitig mit dem Drainanschluss des Transistors 100a kontaktiert und emitterseitig gegen Masse geschaltet. Zwischen dem Kollektoranschluss und dem Basisanschluss des Transistors 102a ist ein Strompfad 112a parallel geschaltet. Der Strompfad 112a umfasst einen Kondensator 114a mit einem in Reihe geschalteten ohmschen Widerstand 116a. Dem Widerstand 116a ist eine gegen Masse kontaktierte Diode 118a nachgeschaltet, wobei zwischen dem Widerstand 116a und der Diode 118a der Basisanschluss eines Transistor 120a angeschlossen ist. Der Transistor 120a ist emitterseitig gegen Masse und kollektorseitig mit dem Strompfad 112a an den Basisanschluss des Transistors 102a geführt. Der Basisanschluss des Transistors 102a ist weiterhin mittels eines ohmschen Widerstands 122a an den Ausgang der Verstärkerstufe 62a sowie an die Z-Diode 108a angeschlossen.

Der Brückenzweig 30a weist zwischen dem Verstärkeranschluss und dem Widerstand 122a die Baugruppe 98 auf. Die Baugruppe 98 weist einen zwischen der Z-Diode 108a und dem Widerstand 122a verschalteten Kondensator 124 auf. Zwischen dem Kondensator 124 und dem Widerstand 122a ist ein ohmscher Widerstand 126 mittels einer Diode 128 gegen Masse geschaltet.

Die Steuersignale Sa und Sb sind im Wesentlichen invertiert zueinander. Dies bedeutet, dass bei einem Einschaltvorgang das Steuersignal Sb des Brückenzweiges 30b im Wesentlichen das Bezugspotential aufweist, wobei das Steuersignal Sa für den Brückenzweig 30a dem Massenpotential entspricht. Dadurch befindet sich der Basisanschluss des Transistors 102a auf Masse und der Gateanschluss des Transistors 100a ist auf Masse zuzüglich der Durchbruchspannung der Z-Diode 108a geschaltet. Dadurch ist der Transistor 102a in einem nicht leitenden und der Transistor 100a in einen leitenden Zustand geschaltet. Im Brückenzweig 30b sind entsprechend der Transistor 102b leitend und der Transistor 100b nicht leitend geschaltet. Dadurch wird ein Stromfluss durch den Transistor 100a und die Primärwicklung 34 zu dem Transistor 102a ermöglicht.

Der Strom steigt an, bis der Transistor 102a dessen Sättigungsbereich überschreitet. In diesem Falle steigt die Spannung an dem Kollektoranschluss des Transistors 102a an, sodass ein Strom durch den Kondensator 114b und den Widerstand 116b in den Basisanschluss des Transistors 120b fließt. Dadurch wird der Transistor 120b leitend, wodurch der Basisanschluss des Transistors 102b auf Masse geschaltet und der Transistor 102b sperrend wird. Die in der Induktivität der Primärwicklung 34 gespeicherte Energie treibt den Strom weiterhin durch den durchgesteuerten Transistor 100a sowie durch die internen Freilaufdioden des Transistors 100b. In der Folge wird der Strom im Wesentlichen vollständig reduziert. Dadurch wird der Transistor 120b sperrend geschaltet, wodurch erneut ein Stromfluss durch den Transistor 102b ermöglicht ist, sodass dieser erneut aufsteuert (Schwingungsvorgang).

Wenn der Transistor 102b durchgesteuert ist, ist die Ausgangsspannung beziehungsweise das Sekundärsignal B des Transformators 20 im Wesentlichen durch das Produkt aus dessen Übersetzungsverhältnis und der Betriebsspannung beziehungsweise des Primärsignals A gegeben. Befindet sich der Flusswander in der Freilaufphase, so fällt an der Primärwicklung 34 lediglich die Spannung über die Freilaufdiode 104a beziehungsweise 104b ab, sodass das Sekundärsignal B im Wesentlichen durch das Produkt aus dem Übersetzungsverhältnis und dieser Spannung als Primärsignal A gegeben ist. Für Freilaufdioden 104a, 104b aus Silizium beträgt diese Spannung typischerweise etwa 0,7 V.

Im Zuge eines Ausschaltvorgangs weist das Steuersignal Sa des Brückenzweiges 30a im Wesentlichen das Bezugspotential auf und das Steuersignal Sb für den Brückenzweig 30b ist auf dem Spannungspegel des Massepotentials. Dadurch ist der Basisanschluss des Transistors 102b auf Masse und der Gateanschluss des Transistors 100b im durchgesteuerten Zustand geschaltet. Im Brückenzweig 30a ist entsprechend der Transistor 100a sperrend und der Transistor 102a leitend geschaltet.

Der Schwingungsvorgang ist aufgrund des ähnlichen Aufbaus der Brückenzweige 30a und 30b im Wesentlichen identisch zu dem vorstehend beschrieben Einschaltvorgang. Durch den Kondensator 124 der Baugruppe 98 wird jedoch der Basisstrom für den Transistor 102a zeitlich begrenzt. Dies führt in der Folge zu einer vergleichsweise geringen Stromaufnahme des Transistors 102a im ausgeschalteten Zustand, sodass der Schwingungsvorgang selbsttätig beendet wird. Bei einem erneuten Einschalten wird der Kondensator 124 über die Diode 128 und den Widerstand 126 entladen.

Das Sekundärsignal B des Transformators 20 weist während des Ausschaltvorgangs im Wesentlichen ein invertiertes Vorzeichen im Vergleich zum Einschaltvorgang auf.

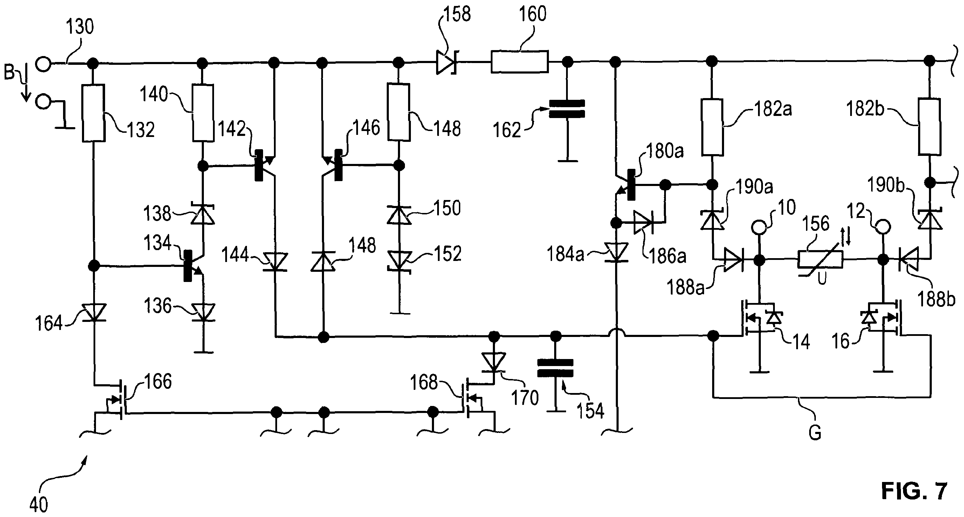

In Abhängigkeit der unterschiedlichen Spannungswerte des Sekundärsignals B des Transformators 20 erzeugt die Treiberschaltung 38 eine Betriebsspannung als (An-)Steuersignale G für die Halbleiterschalter 14 und 16. Der Aufbau der Treiberschaltung 38 ist nachfolgend anhand der Fig. 3 und der Fig. 7 erläutert.

Die Treiberschaltung 38 ist an die Sekundärwicklung 36 des Transformators 20 angeschlossen und ist mittels der Halbleiterschutzschaltung 40 an die Halbleiterschalter 14 und 16 kontaktiert. Der Lastschaltkreis 22 weist hierbei eine an die Sekundärwicklung 36 angeschlossene Leitung 130 auf. An die Leitung 130 ist ein Widerstand 132 der Treiberschaltung 38 geschaltet, hinter dem der Basisanschluss eines Transistors 134 angeschlossen ist. Der Transistor 134 ist emitterseitig mit einer Diode 136 gegen Masse geschaltet und kollektorseitig über eine Z-Diode 138 und einen Widerstand 140 an die Leitung 130 geführt.

Zwischen der Z-Diode 138 und dem Widerstand 140 ist ein Transistor 142 basisseitig angeschlossen. Der Emitteranschluss des Transistors 142 ist an die Leitung 130 angeschlossen und der Kollektoranschluss des Transistors 142 ist über eine Diode 144 an die Gateanschlüsse der Halbleiterschalter 14 und 16 geführt. Parallel zu dem Transistor 142 ist ein Transistor 146 emitterseitig an die Leitung 130 kontaktiert. Der Kollektoranschluss des Transistors 146 ist mittels einer Diode 148 zwischen der Diode 144 und den Gateanschlüssen der Halbleiterschalter 14 und 16 kontaktiert. Parallel zu dem Transistor 146 ist eine gegen Masse geschaltete Reihenschaltung eines Widerstandes 148 und einer Dioden 150 sowie einer Z-Diode 152 an die Leitung 130 angeschlossen. Der Basisanschluss des Transistors 146 ist hierbei zwischen dem Widerstand 148 und der Diode 150 kontaktiert. Die Treiberschaltung 38 umfasst weiterhin einen gegen Masse geschalteten Kondensator 154, welcher zwischen der Diode 148 und den Gateanschlüssen der Halbleiterschalter 14 und 16 kontaktiert ist.

Zum Schutz der Halbleiterschalter 14 und 16 vor einer Beschädigung oder Zerstörung aufgrund einer Überspannung, ist ein Varistor 156 zwischen den Anschlüssen 10 und 12 integriert.

Für einen Einschaltvorgangs der Halbleiterschalter 14 und 16 wird ein positiver Spannungsimpuls als Sekundärsignal B an den Lastschaltkreis 22 übermittelt. Durch die positive Spannung wird der Transistor 134 durchgeschaltet. Bei einer hinreichend hohen (Spannungs-)Amplitude des Sekundärsignals B fließt ein Strom durch den Widerstand 140 und die Z-Diode 138 sowie durch den Transistor 134 und die Diode 136. Fällt eine hinreichend hohe Spannung am Widerstand 140 ab, so schaltet der insbesondere als PNP-Transistor ausgeführte Transistor 142 durch, sodass der Kondensator 154 und die Gates der Halbleiterschalter 14 und 16 aufgeladen werden. Dadurch werden beide Halbleiterschalter 14, 16 leitend geschaltet, sodass ein Stromfluss durch die Anschlüsse 10 und 12 möglich ist.

Da die Treiberschaltung 38 stets erst ab einem bestimmten Schwellwert der Amplitude des Sekundärsignals B durchschaltet, wird der Kondensator 154 während der Freilaufphase des Transformators 20 nicht entladen. Aufgrund der im Betrieb regelmäßig übertragenen Spannungsimpulse wird der Kondensator 154 periodisch nachgeladen, sodass die Halbleiterschalter 14 und 16 stets zuverlässig leitend geschaltet sind. Die Diode 144 verhindert hierbei, dass der Kondensator 154 während der Freilaufphase des Transformators 20 entladen wird.

Bei einem Ausschaltvorgang der Halbleiterschalter 14 und 16 wird ein negativer Spannungsimpuls als Sekundärsignal B an den Lastschaltkreis 22 übermittelt. Weist das Sekundärsignal B eine hinreichend hohe negative (Spannungs-)Amplitude auf, so fließt ein Strom durch den Widerstand 148 und die Diode 150 und die Z-Diode 152. Bei einem hinreichend hohen Spannungsabfall am Widerstand 148 schaltet der insbesondere als NPN-Transistor ausgeführte Transistor 146 durch, sodass der Kondensator 154 und die Gates der Halbleiterschalter 14 und 16 auf eine negative Spannung umgeladen werden. Dadurch werden die Halbleiterschalter 14 und 16 nicht leitend geschaltet, sodass der Stromfluss durch die Anschlüsse 10 und 12 unterbrochen wird. Durch die Ansteuerung mittels einer negativen Spannung ist ein besonders schnelles und zuverlässiges Ausschalten der Halbleiterschalter 14 und 16 gewährleistet.

In einer geeigneten Dimensionierung des Kondensators 154 ist dessen Kapazität einerseits möglichst gering, sodass eine vollständige Aufladung, auch bei vergleichsweise kurzen Spannungsimpulsen des Sekundärsignals B, gewährleistet ist. Dadurch wird verhindert, dass die Halbleiterschalter 14 und 16 unvollständig durchsteuern und somit beschädigt oder zerstört werden.

Andererseits ist eine möglichst große Kapazität des Kondensators 154 wünschenswert, wodurch das die Halbeleiterschalter 14 und 16 steuernde Ansteuersignal G geglättet wird. Dies ist vorteilhaft, da sich der Kondensator 154 und die Gates der Halbleiterschalter 14 und 16 über parasitäre Widerstände während der Freilaufphasen des Transformators 20 entladen können.

Des Weiteren wirkt der Kondensator 154 einem parasitären Ansteuern der Halbleiterschalter 14 und 16 entgegen, wenn eine transiente Spannung über parasitäre Kapazitäten der Halbleiterschalter 14 und 16 auf das jeweilige Gate durchkoppeln. Zur Verbesserung der Sicherheit ist es beispielsweise denkbar, dass die Gates der Halbleiterschalter 14 und 16 mit einem Ansteuersignal G mit einer dauerhaft negativen Spannungsamplitude (Spannungspegel, Spannungswert) versorgt werden.

Im Betrieb der Schaltvorrichtung 8 wird der Stromfluss durch die Halbleiterschalter 14 und 16 mittels der Halbleiterschutzschaltung 40 überwacht. Übersteigt der Stromfluss einen vorgegeben Schwellwert, so werden die Halbleiterschalter 14 und 16 ausgeschaltet, das bedeutet in einen sperrenden Zustand umgeschaltet. Die Halbleiterschalter 14 und 16 bleiben in einem ausgeschalteten Zustand bis die Halbleiterschutzschaltung 40 mittels eines Ausschaltsignals zurückgesetzt wird. Nachfolgend ist der Aufbau der Halbleiterschutzschaltung 40 anhand der Fig. 3 näher erläutert.

Die Halbleiterschutzschaltung 40 ist mittels einer Z-Diode 158 und einem ohmschen Widerstand 160 sowie einem gegen Masse geschalteten Kondensator 162 an die Leitung 130 angeschlossen. Weiterhin ist die Halbleiterschutzschaltung 40 über eine Diode 164 an den Basisanschluss des Transistors 134 der Treiberschaltung 38 gekoppelt. Die Diode 164 ist in Durchlassrichtung an einen Drainanschluss eines sourceseitig gegen Masse geschalteten Transistors 166 kontaktiert. Der Gateanschluss des Transistors 166 ist an den Gateanschluss eines Transistors 168 geführt. Der Transistor 168 ist sourceseitig gegen Masse geschaltet und drainseitig mittels einer Diode 170 zwischen der Diode 148 und dem Kondensator 154 an die Treiberschaltung 38 kontaktiert.

Zwischen den Gateanschlüssen der Transistoren 166 und 168 sind jeweils ein Kondensator 172 und ein ohmscher Widerstand 174 gegen Masse geschaltet. Die Gateanschlüsse der Transistoren 166 und 168 sind weiterhin mittels einer Z-Diode 176 an zwei Stromüberwachungsschaltungen 178a und 178b geführt. Die Stromüberwachungsschaltungen 178a und 178b sind an die Leitung 130 gekoppelt. Die Stromüberwachungsschaltung 178a ist hierbei zwischen den Anschluss 10 und dem Halbleiterschalter 14 kontaktiert. Die Stromüberwachungsschaltung 178b ist entsprechend zwischen der Anschlussklemme des Anschlusses 12 und dem Halbleiterschalter 16 kontaktiert.

Die Stromüberwachungsschaltungen 178a und 178b sind im Wesentlichen gleich aufgebaut, wobei nachfolgend insbesondere der Aufbau der Stromüberwachungsschaltung 178a erläutert ist. Einander entsprechende Teile und Größen der Stromüberwachungsschaltungen 178a und 178b sind jeweils mit entsprechenden Bezugszeichenzusätzen "a" beziehungsweise "b" versehen.

Die Stromüberwachungsschaltung 178a umfasst einen Transistor 180a, einen ohmschen Widerstand 182a, drei Dioden 184a, 186a, 188a und eine Z-Diode 190a. Der Transistor 180a ist kollektorseitig an die Leitung 130 und emitterseitig nach der Z-Diode 176 verschaltet. Zwischen dem Emitteranschluss des Transistors 180a und der Z-Diode 176 ist die Diode 184a verschaltet. Die Diode 186a ist zwischen der Diode 184a und dem Emitteranschluss des Transistors 180a geschaltet, und verbindet den Emitteranschluss des Transistors 180a mit dessen Basisanschluss. Parallel zu dem Transistor 180a ist der Widerstand 182a an die Leitung 130 angeschlossen. Mittels der Z-Diode 190a und der Diode 188a sind der Widerstand 182a und der Basisanschluss des Transistors 180a an die Verschaltungsstelle zwischen dem Anschluss 10 und dem Halbleiterschalter 14 geführt.

Bei einem positiven Wert des Sekundärsignals B wird der Kondensator 162 über die Z-Diode 158 und den Widerstand 160 aufgeladen. Die Zeitkonstante des Ladevorgangs stellt hierbei eine kurze Verzögerung zwischen dem Einschalten der Halbleiterschalter 14 und 16 und dem Aktivieren der Halbleiterschutzschaltung 40 sicher. Die Zeitkonstante ist hierbei vergleichsweise kurz gewählt, sodass auch im Falle eines Einschaltens auf einen Kurzschluss die Halbleiterschalter 14 und 16 zuverlässig und sicher geschützt sind. Die Z-Diode 158 stellt sicher, dass bei einem Sekundärsignal B mit einer negativen Spannungsamplitude eine schnelle Entladung des Kondensators 162 erfolgt, sodass die Halbleiterschutzschaltung 40 bei einem erneuten Einschalten nicht auslöst.

Der Kondensator 162 speist über die Widerstände 182a, 182b und die Dioden 184a, 184b sowie die Z-Dioden 190a, 190b einen Strom in die Drain-Source-Strecke der Halbleiterschalter 14 beziehungsweise 16. Das Potential zwischen den Z-Dioden 190a, 190b und den Widerständen 182a, 182b entspricht der Durchlassspannung der Halbleiterschalter 14 und 16, zuzüglich der Sättigungsspannung der Diode 150 sowie den Durchbruchspannungen der Z-Dioden 190a, 190b. Durch die Kenntnis der Kennlinien der Halbleiterschalter 14 und 16 ist somit eine Überwachung des Stromflusses realisiert. Insbesondere werden die Halbleiterschalter 14 und 16 bei einem Überschreiten eines gewissen Stromwertes (Auslösestrom) ausgeschaltet.

Die Widerstände 182a, 182b sind vergleichsweise hochohmig, sodass der Kondensator 162 zwischen den Nachladeimpulsen des Sekundärsignals B lediglich geringfügig entladen wird. Damit im Fehlerfall ein schnelles Ausschalten ermöglicht ist, wirken die Transistoren 180a, 180b im Auslösefall als Impedanzwandler. Die Dioden 186a, 186b dienen dem Schutz der jeweiligen Transistoren 180a, 180b. Die Dioden 184a und 184b ermöglichen hierbei ein Parallelschalten der Stromüberwachungsschaltungen 178a und 178b.

Steigt die Spannung über der Z-Diode 176 bis auf den Wert deren Durchbruchsspannung, so werden der Kondensator 172 und somit die Gates der insbesondere als NMOS-Transistoren ausgeführten Transistoren 166 und 168 aufgeladen. Wenn diese Ladespannung einen Wert im Bereich der Threshold-Spannungen der Transistoren 166 und 168 erreicht, werden die Drain-Source-Strecken der Transistoren 166 und 168 elektrisch leitfähig. In der Folge wird das Potential an den Gateanschlüssen der Halbleiterschalter 14 und 16 reduziert, wodurch deren elektrische Leitfähigkeit ebenfalls reduziert wird. Dies bewirkt einen weiteren Anstieg der Drain-Source-Spannung und somit zu einem erhöhten Durchsteuern der Transistoren 166 und 168. Aufgrund dieser Mitkopplung werden die Halbleiterschalter 14 und 16 zuverlässig und schnell ausgeschaltet.

Durch eine Anpassung der Z-Diode 176 ist der Wert des Auslösestroms erhöhbar, beziehungsweise mittels der Z-Dioden 190a und 190b reduzierbar.

Bei einer Durchsteuerung des Transistors 166 wird der Basisstrom des Transistors 134 unterbrochen. Dadurch wird der Transistor 142 nicht mehr aufgesteuert, wodurch ein Nachladen des Kondensators 154 verhindert wird.

Der Kondensator 172 und der Widerstand 174 dienen als (RC-)Filter und verhindern ein Auslösen des Überstromschutzes der Halbleiterschutzschaltung 40 bei einem kurzzeitigen Überschreiten des Auslösestroms.

### Bezugszeichenliste

- 2: Laststromkreis
- 4: Last
- 6: Quelle
- 8: Schaltvorrichtung
- 10: Eingangsanschluss
- 12: Ausgangsanschluss
- 14, 16: Halbleiterschalter
- 18: Steuerschaltkreis
- 20: Transformator
- 22: Lastschaltkreis
- 24: Unterspannungsauslöser
- 26: Signalverstärker
- 28: Brückenschaltung
- 30a, 30b: Brückenzweig
- 32: Anschluss
- 34: Primärwicklung
- 36: Sekundärwicklung
- 38: Treiberschaltung
- 40: Halbleiterschutzschaltung
- 42: Diode
- 44: Kondensator
- 46: Spannungsteiler
- 48, 50: Widerstand
- 52: Transistor
- 54: Widerstand
- 56, 58: Transistor
- 60: Eingangsstufe
- 62a, 62b: Verstärkerstufe
- 64: Widerstand
- 66: Kondensator
- 68, 70, 72: Widerstand
- 74: Leitung
- 76: Transistor
- 78: Diode
- 80, 82, 84: Widerstand
- 86, 88: Diode
- 90,92: Kondensator
- 94, 96: Transistor
- 98: Baugruppe
- 100a, 100b: Transistor
- 102a, 102b: Transistor
- 104a, 104b: Freilaufdiode
- 106a, 106b: Widerstand
- 108a, 108b: Z-Diode
- 110a, 110b: Widerstand
- 112a, 112b: Strompfad
- 114a, 114b: Kondensator
- 116a, 116b: Widerstand
- 118a, 118b: Diode
- 120a, 120b: Transistor
- 122a, 122b: Widerstand
- 124: Kondensator
- 126: Widerstand
- 128: Diode
- 130: Leitung
- 132: Widerstand
- 134: Transistor
- 136: Diode
- 138: Z-Diode
- 140: Widerstand
- 142: Transistor
- 144: Diode
- 146: Transistor
- 148: Widerstand
- 150: Diode
- 152: Z-Diode
- 154: Kondensator
- 156: Varistor
- 158: Z-Diode
- 160: Widerstand
- 162: Kondensator
- 164: Diode
- 166, 168: Transistor
- 170: Diode
- 172: Kondensator
- 174: Widerstand
- 176: Z-Diode
- 178a, 178b: Stromüberwachungsschaltung
- 180a, 180b: Transistor
- 182a, 182b: Widerstand
- 184a, 184b: Diode
- 186a, 186b: Diode
- 188a, 188b: Diode
- 190a, 190b: Z-Diode

- Uv: Versorgungsspannung
- S, Sa, Sb: Schwellwertsignal
- A: Primärsignal
- B: Sekundärsignal/Ausgangsspannung
- G: Ansteuersignal/Betriebsspannung

## Patentansprüche

1. Verfahren zur Ansteuerung eines in einen Laststromkreis (2) geschalteten elektronischen Halbleiterschalters (14, 16), welcher zwischen einem an eine Quelle (6) geführten Eingangsanschluss (10) und einem an eine Last (4) geführten Ausgangsanschluss (12) des Laststromkreis (2) geschaltet ist,
- mit einem an eine Versorgungsspannung (Uv) angeschlossenen Steuerschaltkreis (18) mit einer primärseitig an einen Transformator (20) und an die Versorgungsspannung (Uv) angeschlossenen Brückenschaltung (28) mit zwei Brückenzweigen (30a, 30b), zwischen denen eine Primärwicklung (34) des Transformators (20) verschaltet ist, und
- mit einem sekundärseitig an den Transformator (20) angeschlossenen Lastsschaltkreis (22) mit einer Treiberschaltung (38) für den Halbleiterschalter (14, 16),
- wobei die Brückenschaltung (28) als ein selbstschwingender Flusswandler ausgeführt ist,
- wobei der Brückenschaltung (28) ansteuerseitig ein Schwellwertsignal (S, Sa, Sb) zugeführt wird,
- wobei die Brückenschaltung (28) ein Primärsignal (A) erzeugt, das als Sekundärsignal (B) an den vom Steuerschaltkreis (18) galvanisch getrennten Lastschaltkreis (22) übertragen wird und
- wobei das Sekundärsignal (B) der Treiberschaltung (38) zugeführt wird, welche ein Ansteuersignal (G) für den Halbleiterschalter (14, 16) erzeugt,
**dadurch gekennzeichnet, dass**
- der oder jeder Halbleiterschalter (14, 16) mittels einer an die Treiberschaltung (38) und an den Transformator (20) gekoppelten Halbleiterschutzschaltung (40) des Lastschaltkreises (22) auf einen Überstrom überwacht wird, und dass
- ein Laststrom des Laststromkreises (2) von der Halbleiterschutzschaltung (40) über einen Spannungsabfall am Halbleiterschalter (14, 16) selbst und anhand einer Kennlinie des Halbleiterschalters (14, 16) überwacht wird.

2. Verfahren nach Anspruch 1,
**dadurch gekennzeichnet,**
**dass** das Schwellwertsignal (S) mittels eines der Brückenschaltung (28) vorgeschalteten Signalverstärkers (26) verstärkt wird.

3. Verfahren nach Anspruch 1 oder 2,
**dadurch gekennzeichnet,**
**dass** der Halbleiterschalter (14, 16) zum Umschalten in den Ausschaltzustand mit einem negativen Spannungswert des Ansteuersignal (G) der Treiberschaltung (38) angesteuert wird.

4. Elektronische Schaltvorrichtung (8) zum Unterbrechen eines Laststromkreises (2) mit mindestens einem zwischen einem an eine Quelle (6) geführten Eingangsanschluss (10) und einem an eine Last (4) geführten Ausgangsanschluss (12) geschalteten elektronischen Halbleiterschalter (14, 16), mit einem an eine Versorgungsspannung (Uv) angeschlossenen Steuerschaltkreis (18) mit einer primärseitig an einen Transformator (20) und an die Versorgungsspannung (Uv) angeschlossenen Brückenschaltung (28) mit zwei Brückenzweigen (30a, 30b), zwischen denen eine Primärwicklung (34) des Transformators (20) verschaltet ist, und mit einem sekundärseitig an den Transformator (20) angeschlossenen Lastsschaltkreis (22) mit einer Treiberschaltung (38) für den Halbleiterschalter (14, 16),
- wobei die Brückenschaltung (28) als ein selbstschwingender Flusswandler ausgeführt ist,
- wobei der Transformator (20) von dem Steuerschaltkreis (18) ein Primärsignal (A) als ein Sekundärsignal (B) an den galvanisch getrennten Lastschaltkreis (22) überträgt und
- wobei das Sekundärsignal (B) des Transformators (20) an die Treiberschaltung (38) geführt ist, welche ein Ansteuersignal (G) für den Halbleiterschalter (14, 16) erzeugt, **dadurch gekennzeichnet, dass**
- der oder jeder Halbleiterschalter (14, 16) mittels einer an die Treiberschaltung (38) und an den Transformator (20) gekoppelten Halbleiterschutzschaltung (40) des Lastschaltkreises (22) auf einen Überstrom überwacht ist, und dass
- die Halbleiterschutzschaltung (40) einen Laststrom des Laststromkreises (2) über einen Spannungsabfall am Halbleiterschalter (14, 16) selbst und anhand einer Kennlinie des Halbleiterschalters (14, 16) überwacht.

5. Schaltvorrichtung (8) nach Anspruch 4,
**dadurch gekennzeichnet,**
**dass** der Steuerschaltkreis (18) über einen Unterspannungsauslöser (24) an die Versorgungsspannung (Uv) angeschlossen ist.

6. Schaltvorrichtung (8) nach Anspruch 4 oder 5,
**dadurch gekennzeichnet,**
**dass** der Brückenschaltung (28) ein Signalverstärker (26) vorgeschaltet ist.

7. Schaltvorrichtung (8) nach Anspruch 6,
**dadurch gekennzeichnet,**
**dass** der Signalverstärker (26) zwei hintereinander geschaltete Verstärkerstufen (62a, 62b) aufweist, die ausgangsseitig jeweils an einen Brückenzweig (30a, 30b) der Brückenschaltung (28) geführt ist.

8. Schaltvorrichtung (8) nach einem der Ansprüche 4 bis 7,
**dadurch gekennzeichnet,**
**dass** zum bidirektionalen Überlastschutz des Laststromkreises (22) zwei in Reihe geschaltete Halbleiterschalter (14, 16) zwischen einen Eingangsanschluss (10) und einen Ausgangsanschluss (12) des Laststromkreis (2) geschaltet sind.

9. Schaltvorrichtung (8) nach Anspruch 8,
**dadurch gekennzeichnet,**
**dass** den Halbleiterschaltern (14, 16) ein Varistor (156) als Überspannungsschutz parallel geschaltet ist.

## Claims

1. Method for controlling an electronic semiconductor switch (14, 16) which is connected into a load circuit (2) and is connected between an input connection (10) of the load circuit (2) that is connected to a source (6) and an output connection (12) of the load circuit (2) that is connected to a load (4),
- having a control circuit (18) which is connected to a supply voltage (Uv) and has a bridge circuit (28) which is connected, on the primary side, to a transformer (20) and to the supply voltage (Uv) and has two bridge arms (30a, 30b), between which a primary winding (34) of the transformer (20) is connected, and
- having a load switching circuit (22) which is connected, on the secondary side, to the transformer (20) and has a driver circuit (38) for the semiconductor switch (14, 16),
- wherein the bridge circuit (28) is in the form of a self-oscillating forward converter,
- wherein a threshold value signal (S, Sa, Sb) is supplied to the bridge circuit (28) on the control side,
- wherein the bridge circuit (28) generates a primary signal (A) which is transmitted, as a secondary signal (B), to the load switching circuit (22) DC-isolated from the control circuit (18), and
- wherein the secondary signal (B) is supplied to the driver circuit (38) which generates a control signal (G) for the semiconductor switch (14, 16),
**characterized in that**
- the or each semiconductor switch (14, 16) is monitored for an overcurrent by means of a semiconductor protective circuit (40) of the load switching circuit (22), said semiconductor protective circuit being coupled to the driver circuit (38) and to the transformer (20), and **in that**
- a load current of the load circuit (2) is monitored by the semiconductor protective circuit (40) via a voltage drop across the semiconductor switch (14, 16) and on the basis of a characteristic curve of the semiconductor switch (14, 16).

2. Method according to Claim 1,
**characterized**
**in that** the threshold value signal (S) is amplified by means of a signal amplifier (26) connected upstream of the bridge circuit (28).

3. Method according to Claim 1 or 2,
**characterized**
**in that** the semiconductor switch (14, 16) is controlled to change over to the switched-off state with a negative voltage value of the control signal (G) from the driver circuit (38).

4. Electronic switching apparatus (8) for interrupting a load circuit (2) having at least one electronic semiconductor switch (14, 16) which is connected between an input connection (10) connected to a source (6) and an output connection (12) connected to a load (4), having a control circuit (18) which is connected to a supply voltage (Uv) and has a bridge circuit (28) which is connected, on the primary side, to a transformer (20) and to the supply voltage (Uv) and has two bridge arms (30a, 30b), between which a primary winding (34) of the transformer (20) is connected, and having a load switching circuit (22) which is connected, on the secondary side, to the transformer (20) and has a driver circuit (38) for the semiconductor switch (14, 16),
- wherein the bridge circuit (28) is in the form of a self-oscillating forward converter,
- wherein the transformer (20) transmits a primary signal (A) from the control circuit (18), as a secondary signal (B), to the DC-isolated load switching circuit (22), and
- wherein the secondary signal (B) from the transformer (20) is supplied to the driver circuit (38) which generates a control signal (G) for the semiconductor switch (14, 16),
**characterized in that**
- the or each semiconductor switch (14, 16) is monitored for an overcurrent by means of a semiconductor protective circuit (40) of the load switching circuit (22), said semiconductor protective circuit being coupled to the driver circuit (38) and to the transformer (20), and **in that**
- the semiconductor protective circuit (40) monitors a load current of the load circuit (2) via a voltage drop across the semiconductor switch (14, 16) and on the basis of a characteristic curve of the semiconductor switch (14, 16).

5. Switching apparatus (8) according to Claim 4, **characterized**
**in that** the control circuit (18) is connected to the supply voltage (Uv) via an undervoltage release (24).

6. Switching apparatus (8) according to Claim 4 or 5, **characterized**
**in that** a signal amplifier (26) is connected upstream of the bridge circuit (28).

7. Switching apparatus (8) according to Claim 6, **characterized**
**in that** the signal amplifier (26) has two amplifier stages (62a, 62b) which are connected in series and are each connected, on the output side, to a bridge arm (30a, 30b) of the bridge circuit (28).

8. Switching apparatus (8) according to one of Claims 4 to 7,
**characterized**
**in that**, for bidirectional overload protection of the load circuit (22), two semiconductor switches (14, 16) connected in series are connected between an input connection (10) of the load circuit (2) and an output connection (12) of the load circuit (2).

9. Switching apparatus (8) according to Claim 8, **characterized**
**in that** a varistor (156) is connected in parallel with the semiconductor switches (14, 16) as overvoltage protection.

## Revendications

1. Procédé de commande d'un commutateur électronique à semi-conducteur (14, 16) qui est monté dans un circuit de charge (2) et qui est monté entre une borne d'entrée (10), menant à une source (6), et une borne de sortie (12), menant à une charge (4), du circuit de charge (2), ledit commutateur électronique à semi-conducteur comprenant
- un circuit de commande (18) qui est raccordé à une tension d'alimentation (Uv) et qui comporte un circuit en pont (28) qui est raccordé du côté primaire à un transformateur (20) et à la tension d'alimentation (Uv) et qui comporte deux branches en pont (30a, 30b) entre lesquels un enroulement primaire (34) du transformateur (20) est monté, et
- un circuit de charge (22) qui est raccordé du côté secondaire au transformateur (20) et qui comporte un circuit d'attaque (38) destiné au commutateur à semi-conducteur (14, 16),
- le circuit en pont (28) étant réalisé sous la forme d'un convertisseur de flux auto-oscillant,
- un signal de valeur de seuil (S, Sa, Sb) étant amené au circuit en pont (28) du côté commande,
- le circuit en pont (28) générant un signal primaire (A) qui est transmis en tant que signal secondaire (B) au circuit de charge (22) qui est séparé galvaniquement du circuit de commande (18) et
- le signal secondaire (B) étant amené au circuit d'attaque (38) qui génère un signal d'attaque (G) destiné au commutateur à semi-conducteur (14, 16), **caractérisé en ce que**
- le ou chaque commutateur à semi-conducteur (14, 16) est surveillé en termes de surintensité au moyen d'un circuit de protection à semi-conducteur (40) du circuit de charge (22) qui est couplé au circuit d'attaque (38) et au transformateur (20), et
- un courant de charge du circuit de charge (2) est surveillé par le circuit de protection à semi-conducteur (40) en termes de chute de tension au niveau du commutateur à semi-conducteur (14, 16) lui-même et à l'aide d'une courbe caractéristique du commutateur à semi-conducteur (14, 16).

2. Procédé selon la revendication 1,
**caractérisé en ce que**
le signal de valeur de seuil (S) est amplifié au moyen d'un amplificateur de signal (26) monté en amont du circuit en pont (28).

3. Procédé selon la revendication 1 ou 2,
**caractérisé en ce que**
le commutateur à semi-conducteur (14, 16) est commandé avec une valeur de tension négative du signal de commande (G) du circuit d'attaque (38) afin de passer à l'état désactivé.

4. Dispositif de commutation électronique (8) destiné à interrompre un circuit de charge (2) comprenant au moins un commutateur électronique à semi-conducteur (14, 16) qui est monté entre une borne d'entrée (10), menant à une source (6), et une borne de sortie (12), menant à une charge (4), un circuit de commande (18) qui est raccordé à une tension d'alimentation (Uv) et qui comporte un circuit en pont (28) raccordé du côté primaire à un transformateur (20) et à la tension d'alimentation (Uv) et comportant deux branches de pont (30a, 30b) entre lesquelles un enroulement primaire (34) du transformateur (20) est monté, et un circuit de charge (22) qui est raccordé du côté secondaire au transformateur (20) et qui comporte un circuit d'attaque (38) destiné au commutateur à semi-conducteur (14, 16),
- le circuit en pont (28) étant réalisé sous la forme d'un convertisseur de flux auto-oscillant,
- le transformateur (20) transmettant un signal primaire (A), provenant du circuit de commande (18), en tant que signal secondaire (B) au circuit de charge (22) qui est séparé galvaniquement et
- le signal secondaire (B) du transformateur (20) étant amené au circuit d'attaque (38) qui génère un signal de commande (G) destiné au commutateur à semi-conducteur (14, 16), **caractérisé en ce que**
- le ou chaque commutateur à semi-conducteur est surveillé en termes de surintensité au moyen d'un circuit de protection à semi-conducteur (40) du circuit de charge (22) qui est couplé au circuit d'attaque (38) et au transformateur (20), et
- le circuit de protection à semi-conducteur (40) surveillant un courant de charge du circuit de charge (2) en termes de chute de tension au niveau du commutateur à semi-conducteur (14, 16) lui-même et à l'aide d'une courbe caractéristique du commutateur à semi-conducteur (14, 16).

5. Dispositif de commutation (8) selon la revendication 4,
**caractérisé en ce que**
le circuit de commande (18) est raccordé à la tension d'alimentation (Uv) par le biais d'un déclencheur à minimum de tension (24).

6. Dispositif de commutation (8) selon la revendication 4 ou 5,
**caractérisé en ce que**
le circuit en pont (28) est monté en amont d'un amplificateur de signal (26).

7. Dispositif de commutation (8) selon la revendication 6,
**caractérisé en ce que**
l'amplificateur de signal (26) comporte deux étages amplificateurs (62a, 62b) qui sont montés en série et qui mènent chacun du côté sortie à une branche de pont (30a, 30b) du circuit en pont (28).

8. Dispositif de commutation (8) selon l'une des revendications 4 à 7,
**caractérisé en ce que**
deux commutateurs à semi-conducteurs (14, 16) montés en série sont montés entre une borne d'entrée (10) et une borne de sortie (12) du circuit de charge (2) afin d'effectuer la protection bidirectionnelle contre les surcharges du circuit de charge (22).

9. Dispositif de commutation (8) selon la revendication 8,
**caractérisé en ce que**
une varistance (156) est montée en parallèle avec les commutateurs à semi-conducteur (14, 16) en tant que protection contre les surtensions.
